# EUROPEAN PATENT SPECIFICATION

(11) **EP 1 376 665 B1**
(45) Date of publication and mention of the grant of the patent: **14.11.2007**
(21) Application number: 02705172.1
(22) Date of filing: 14.03.2002
(51) Int. Cl.: H01L 21/205, C23C 16/44

(54) **GASEOUS PHASE GROWING DEVICE**
GASPHASEN-AUFWACHSEINRICHTUNG
DISPOSITIF DE CROISSANCE DE PHASE GAZEUSE

(30) Priority: 30.03.2001 JP 2001100848
(43) Date of publication of application: 02.01.2004
(73) Proprietor: Shin-Etsu Handotai Co., Ltd, Tokyo 100-0005 (JP)
(72) Inventor: ARAI, Takeshi, c/o Shin-Etsu Handotai Co., Ltd., Annaka-shi, Gunma 379-0196 (JP)
(74) Representative: Jones, Helen M.M.
(86) International application number: PCT/JP2002/002405
(87) International publication number: WO 2002/082516

(56) References cited:
- EP-A2- 0 953 659
- JP-A- 11 104 950
- JP-U- 1 167 034
- US-A- 6 146 504
- PATENT ABSTRACTS OF JAPAN vol. 2000, no. 14, 5 March 2001 (2001-03-05) & JP 2000 323556 A (KOMATSU ELECTRONIC METALS CO LTD), 24 November 2000 (2000-11-24)
- PATENT ABSTRACTS OF JAPAN vol. 1995, no. 04, 31 May 1995 (1995-05-31) & JP 07 022489 A (TOSHIBA CORP), 24 January 1995 (1995-01-24)

## Description

### Technical field

The present invention relates to a vapor phase growth apparatus which performs installation and removal of a substrate on a susceptor by making lift pins go up and down.

### Background Art

A single wafer type vapor phase growth apparatus has been known as a vapor phase growth apparatus for growing a single crystal thin film or the like on a semiconductor substrate, such as silicon or the like, in vapor phase.

The single wafer type vapor phase growth apparatus comprises a susceptor in a reaction chamber in which source gas is supplied. A pocket portion for taking the substrate therein is formed on the susceptor.

Then, lift pins are arranged so as to be slid freely by passing into through holes provided on the pocket portion. Each lift pin is arranged so that its head portion may be faced to the pocket portion. Then, the lift pins are made to go up and down and their heads are in contact with and separated from the rear surface of the substrate. Thereby, the substrate can be taken in the pocket portion, or the substrate can be taken out of the pocket portion. A corresponding apparatus is disclosed in JP-A-2000/323 556.

That is, the substrate is taken in the pocket portion by sliding the lift pins and burying their head portions in the pocket portion in a state that the substrate is placed on the head portions of the lift pins. Thus, the substrate is taken in the pocket portion, and the source gas is supplied in the reaction chamber, and then, a single crystal thin film is grown on the substrate in vapor phase. The substrate after vapor phase growth is pushed out upwardly by pushing out the head portions of the lift pins from the pocket portion. The pushed-out substrate is carried to the outside of the reaction chamber with a transportation means, such as a handler or the like.

Incidentally, with the semiconductor substrate manufactured with the above-mentioned vapor phase growth apparatus, it is required to reduce a few crystal defects generated in the vicinity of its surface or particles adhered to the surface of the semiconductor substrate so as not to affect the characteristics of a semiconductor device which recently tends to be minimized and larger scale integration. Therefore, in the future vapor phase growth apparatus, technological development becomes a considerably important subject for manufacturing a semiconductor substrate that no crystal defect is generated or no particle is adhered.

An object of the present invention is to provide a vapor phase growth apparatus which can reduce adhesion of particles or formation of crystal defects caused during vapor phase growth.

### Disclosure of the Invention

In order to solve the above problems, the inventor eagerly carried out researches repeatedly. As a result, the inventor paid attention to abraded particles generated by sliding the lift pins, as one of the causes of crystal defects or particles generated during vapor phase growth. As lift pins in earlier technology, the ones that an SiC (Silicon Carbide) film is formed on the surface of a base material by a CVD (Chemical Vapor Deposition; chemical vapor phase growth) method have been used. The lift pins in earlier technology, in which the SiC film is formed by the CVD method, have around 100 µm of surface roughness. Then, the inventor realized that generation of crystal defects or particles caused during the vapor phase growth can be controlled by making the surface roughness of the lift pins not more than 5 µm. Therefore, the present invention was made.

That is, the vapor phase growth apparatus of the present invention comprises: a reaction chamber; a susceptor for placing a substrate thereon, the susceptor being provided in the reaction chamber; a pocket portion formed in the susceptor, the pocket portion being provided with through holes; and lift pins each of which is inserted into each of the through holes, the lift pins being arranged so as to slide freely. Installation and removal of the substrate on the susceptor are made by lifting down the lift pins and making the lift pins be in contact with and separated from a rear surface of the substrate, and a surface of each of the lift pins that slides in contact with the susceptor is polished.

In the vapor phase growth apparatus of the present invention, the surface of each of the lift pins that slides in contact with the susceptor is preferably formed so that surface roughness is not more than 5 µm.

Further, in the vapor phase growth apparatus of the present invention, a surface of the susceptor that slides in contact with each of the lift pins is preferably formed so that surface roughness is not more than 5 µm.

Further, in the vapor phase growth apparatus of the present invention, a surface of each of the lift pins and a surface of the susceptor is preferably formed with SiC.

According to the vapor phase growth apparatus of the present invention, since the surface of each of the lift pins that slides in contact with the susceptor is polished, each of the lift pins becomes to slide more smoothly in a process of installing and removing the substrate on the susceptor by making the lift pins go up and down. That is, the abraded particles generated from the surface of each of the lift pins can be reduced considerably. Thereby, scattering of the abraded particles in the reaction chamber is reduced, and adhesion of foreign material, such as abraded particles or the like, can be reduced considerably. Therefore, generation of crystal defects or particles on a thin film for being grown on the substrate in vapor phase can be reduced considerably.

### Brief Description of Drawings

FIG. 1 shows a vapor phase growth apparatus of an embodiment to which the present invention is applied, and is a view showing a state that a wafer is pushed out upwardly from a pocket portion;
FIG. 2 is a view showing a state that the wafer is taken in the pocket portion, in the vapor phase growth apparatus in FIG. 1;
FIG. 3 is a graph showing results of measurement of particles larger than 0.13 µm, with respect to an epitaxial wafer obtained by using lift pins of an example;
FIG. 4 is a graph showing results of measurement of particles larger than 20 µm, with respect to an epitaxial wafer obtained by using the lift pins of the example;
FIG. 5 is a graph showing results of measurement of particles larger than 0.13 µm, with respect to an epitaxial wafer obtained by using lift pins in earlier technology; and
FIG. 6 is a graph showing results of measurement of particles larger than 20 µm, with respect to an epitaxial wafer obtained by using the lift pins in the earlier technology.

### Best Mode for Carrying out the Invention

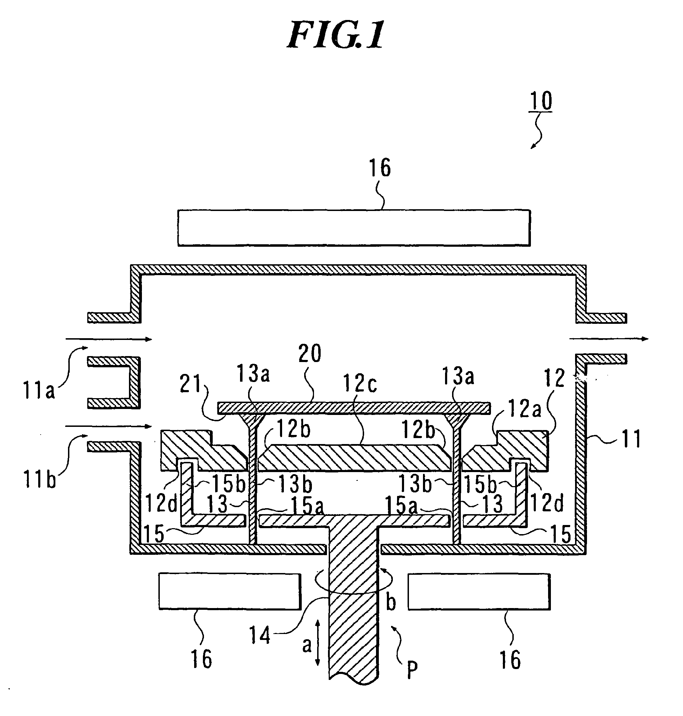

Hereinafter, a vapor phase growth apparatus 10 of an embodiment of the present invention will be explained in detail with reference to FIGS. 1 to 6.

As shown in FIG. 1, the vapor phase growth apparatus 10 comprises a function as a reactor of a single wafer type, and comprises a susceptor 12 in a reaction chamber 11. The susceptor 12 comprises a pocket portion 12a on the upper surface thereof, and a silicon wafer (substrate) 20 (hereinafter, a wafer 20) is placed on the bottom surface 12c of the pocket portion 12a. Further, the susceptor 12 is supported by a support means P from its back surface. The support means P comprises a rotating shaft 14. The rotating shaft 14 is arranged so as to be movable in up and down direction shown by an arrow a, and is arranged so as to be rotatable in the direction shown by an arrow b. A plurality of spokes 15 are branched radially from the front end portion of the rotating shaft 14. A vertical pin 15b is provided on a front end of each spoke 15, and a front end of the vertical pin 15b is inserted into a concave portion 12d formed on the rear surface of the susceptor 12.

Further, the susceptor 12 comprises lift pins 13, and the diameter of the head portion 13a of each lift pin 13 is expanded. Each lift pin 13 is inserted into a through hole 12b provided in the bottom surface 12c of the pocket portion 12a, and its head portion 13a is arranged so as to face the bottom surface 12c of the pocket portion 12a. Moreover, a shaft portion 13b of each lift pin 13 passes through a through hole 15a provided in the spokes 15.

Incidentally, the above-described lift pins 13 are made by forming an SiC film on a surface of a base material made from SiC by a CVD method, and thereafter, by polishing so that its surface roughness will become not more than 5 µm. Further, the susceptor 12 is made by forming an SiC film on a surface of a base material made from carbon.

Further, in the susceptor 12 of the embodiment, the portions which slide in contact with the lift pins 13 are polished so that the surface roughness will be not more than 5 µm. In particular, the inner surface of each through hole 12b of the susceptor 12 is polished so that the surface roughness will be not more than 5 µm.

According to such a vapor phase growth apparatus 10, epitaxial growth of a single crystal thin film, such as silicon or the like, can be carried out on the wafer 20 as the following.

At first, as shown in FIG. 1, when the support means P is made to go down in a state that the rear end of each lift pin 13 is in contact with the bottom surface of the reaction chamber 11, the head portion 13a of each lift pin 13 is pushed out from the bottom surface 12c of the pocket portion 12a. The wafer 20 is placed on the head portions 13a so that its rear surface 21 will be in contact with the head portions 13a.

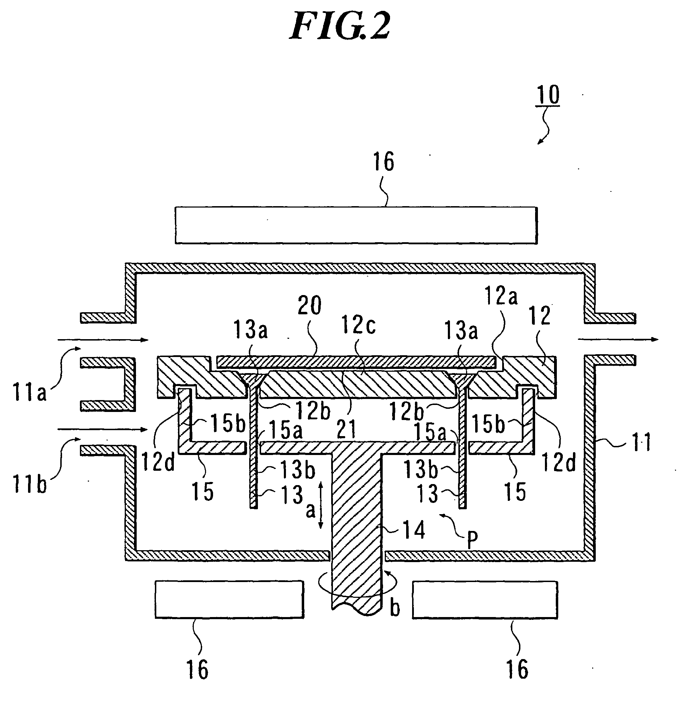

When the support means P is made to go up in this state, the susceptor 12 goes up while the shaft portion 13b of each lift pin 13 is slid in contact with the inner surface of each through hole 12b. Then, when the susceptor 12 is made to go up until the head portion 13a of each lift pin 13 is buried in the bottom surface 12c of the pocket portion 12a, the wafer 20 is placed on the bottom surface 12c of the pocket portion 12a. The support means P is further made to go up, and the wafer 20 is located in a predetermined height, as shown in FIG. 2.

Thus, the wafer 20 is placed in the reaction chamber 11, and the wafer 20 is rotated by rotating the rotating shaft 14. Moreover, the wafer 20 is heated with the infrared lamps 16 from the upper and lower sides. Thus, epitaxial growth of a single crystal thin film is carried out on the wafer 20. In this case, source gas is supplied with H₂ gas, which becomes carrier gas, from a feed pipe 11a provided in the upper side. Further, H₂ gas, which becomes purge gas, is supplied at a pressure higher than the above-described source gas. Thereby, the source gas is supplied by forming an almost laminar flow on the surface of the wafer 20, without flowing into the downward of the susceptor 12.

In order to take out the wafer 20 to which the epitaxial growth is completed, from the susceptor 12, the support means P is made to go down. When the support means P is made to go down, the rear end of each lift pin 13 is in contact with the bottom surface of the reaction chamber 11. When the support means P is further made to go down, the head portion 13a of each lift pin 13 which is in contact with the rear surface 21 of the wafer 20 pushes out the wafer 20 upwardly from the pocket portion 12a (the state that the wafer 20 is pushed out is shown in FIG. 1). In such a state that the wafer 20 is pushed out, a non-shown handler is inserted in between the susceptor 12 and the wafer 20, and transfer and transportation of the wafer 20 are performed.

In addition, in FIG. 1 and FIG. 2, two pins out of the lift pins 13 are shown in a cross section. However, the lift pins 13 are arranged in three places which are mutually separated at equal intervals, and they push out the wafer 20 from three points.

### Example

An SiC film was formed in a predetermined film thickness on the surface of the lift pins 13 by the CVD method. Then, it was polished with a grinder until its surface roughness in the portion which shows the largest value becomes 5 µm. This polishing was performed to the whole surface of the lift pins 13. In addition, the polished surface of each lift pin 13 was cut off, and the vicinity of its surface was observed with a SEM (Scanning Electron Microscope). It was confirmed that the polishing was performed until the surface roughness becomes not more than 5 µm by measuring the unevenness of the polished surface. Further, in the polishing with the grinder, in consideration of forming an SiC film on the surface of the lift pins 13, an SiC grind stone made from the same material was used (hereinafter, it is called "same material abrasive polishing"). Thus, foreign material can be prevented from being mixed into the polished surface of the SiC film by performing the same material abrasive polishing. The polished powder was removed sufficiently by cleaning the polished surface, so that the lift pins 13 were obtained. Further, the inner surface of each through hole 12b of the susceptor 12 was polished so that the surface roughness will become not more than 5 µm as the same.

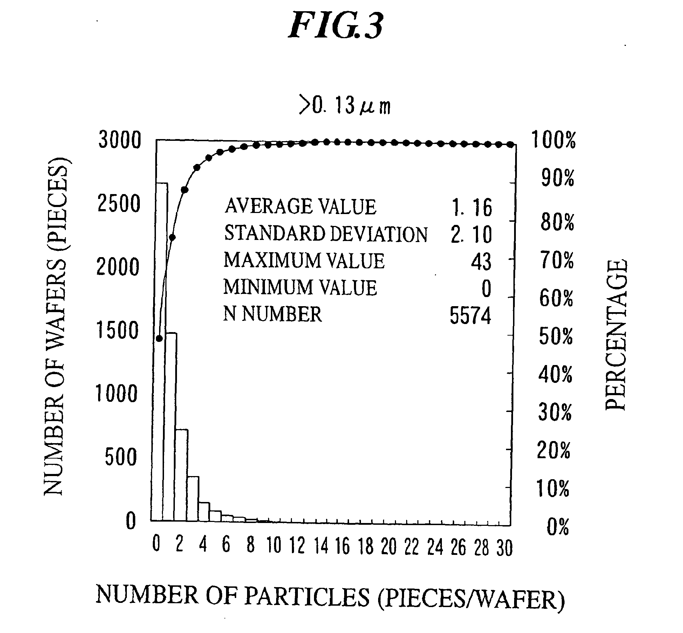

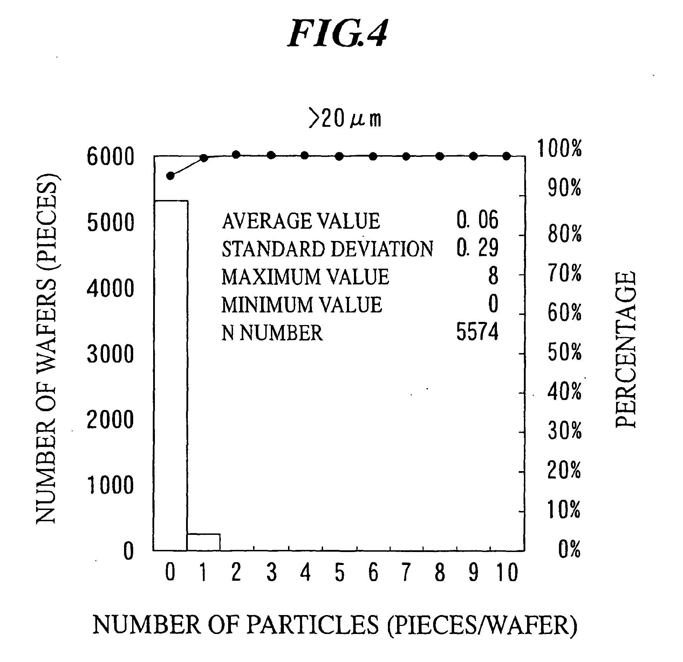

The obtained lift pins 13 were used in the single wafer type vapor phase growth apparatus 10. The number of particles on each wafer 20 taken out from the vapor phase growth apparatus 10 after the epitaxial growth was completed was measured. The results are shown in FIG. 3 and FIG. 4. The measurement of the particles was performed by a light-scattering type wafer particle inspection apparatus. In addition, the crystal defects generated in the vicinity of the surface were measured as particles by the light-scattering type wafer particle inspection apparatus. Further, FIG. 3 shows the results of measurement of the particles larger than 0.13 µm, and FIG. 4 shows the results of measurement of the particles larger than 20 µm. Further, in FIG. 3 and FIG. 4, the abscissa axis shows the number of measured particles, and the ordinate axis shows the number of wafers 20. Further, the N number of the measured wafers 20 was 5574 pieces.

In both FIG. 3 and FIG. 4, the wafers which no particle was measured are the most, and the number of wafers tends to decrease gradually with the increase of particles. Then, as shown in FIG. 3, when the particles larger than 0.13 µm were measured, the wafers in which no particle was measured occupies about 50% of the whole. The average value of the particles measured per one wafer was 1.16 pieces/wafer, and the standard deviation was 2.10. Further, as shown in FIG. 4, when the particles larger than 20 µm were measured, the wafers in which no particle was measured occupies about 95% of the whole. The average value of the particles was 0.06 pieces/wafer, and the standard deviation was 0.29.

### Comparative example

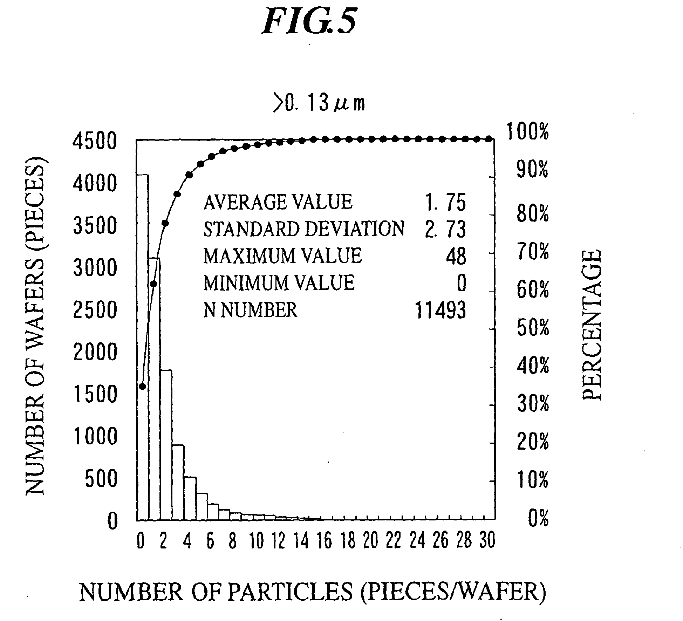

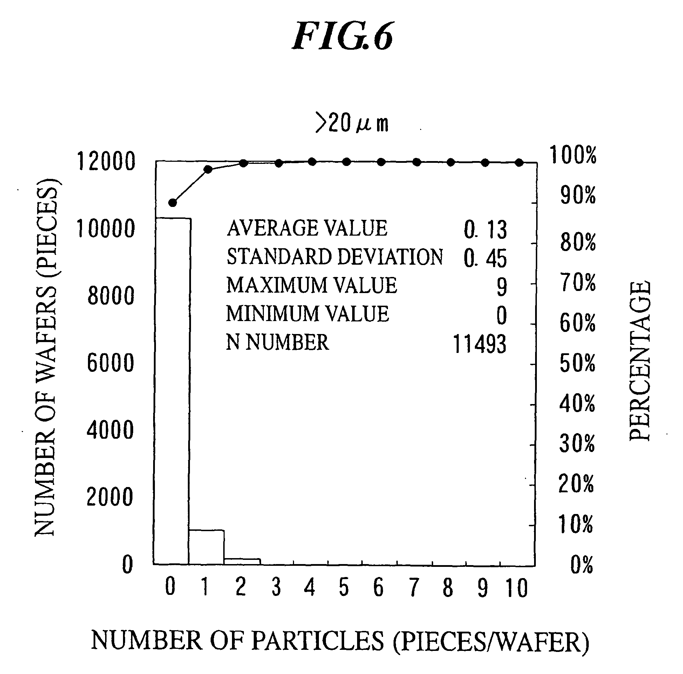

The results of performing epitaxial growth by a single wafer type vapor phase growth apparatus by using lift pins in earlier technology are shown in FIG. 5 and FIG. 6. The lift pins were used in a state just forming an SiC film on the whole surface by the CVD method, and the surface roughness was about 100 µm in the portion which shows the largest value. In addition, FIG. 5 is the results with respect to the particles larger than 0.13 µm, and FIG. 6 is the results with respect to the particles larger than 20 µm. Further, the abscissa axis and the ordinate axis are the same as in FIG. 3 and FIG. 4, and the N number of the measured wafers was 11493 pieces.

In both FIG. 5 and FIG. 6, as the same as in FIG. 3 and FIG. 4, the number of wafers tends to decrease gradually with the increase of particles. However, as shown in FIG. 5, when the particles larger than 0.13 µm were measured, the wafers in which no particle was measured is about 35% of the whole. The average value of the particles was 1.75 pieces/wafer, and the standard deviation was 2.73. Further, as shown in FIG. 6, when the particles larger than 20 µm were measured, the wafers in which no particle was measured is about 90% of the whole. The average value of the particles was 0.13 pieces/wafer, and the standard deviation was 0.45.

According to the examples and the comparative example in the above, it can be realized that the number of particles measured after the epitaxial growth is reduced by using the lift pins 13 of the example rather than by using the lift pins in the earlier technology.

That is, comparing FIG. 3 and FIG. 5, the wafers in which no particle was measured is around 35% of the whole in the comparative example, on the contrary, it is realized that the wafers in which no particle was measured is increased to around 50% of the whole in the example. Further, the average value of the particles is 1.75 pieces/wafer in the comparative example, on the contrary, that in the example is reduced to 1.16 pieces/wafer. Moreover, the standard deviation is 2.73 in the comparative example, on the contrary, the standard deviation in the example is reduced to 2.10.

Similarly, comparing FIG. 4 and FIG. 6, the wafers in which no particle was measured is around 90% of the whole in the earlier technology, however, it is increased to around 95% in the example. Further, the average value of the particles is reduced from 0.13 pieces/wafer to 0.06 pieces/wafer, and the standard deviation is reduced from 0.45 to 0.29.

Thus, an epitaxial wafer that adhesion of particles or formation of crystal defects is reduced can be obtained in a high yield by reducing the abraded particles generated during the epitaxial growth.

In addition, the present invention is not limited to the above-described embodiment.

For example, the whole surface of the lift pins 13 of the present invention may be polished, or the portion of the surface of each lift pin 13, which is slid in contact with the susceptor, may be polished when the wafer 20 is placed on the bottom surface 12c of the pocket portion 12a or when the wafer 20 is pushed out from the bottom surface 12c of the pocket portion 12a.

Further, in the example, the lift pins 13 were polished by same material abrasive polishing with SiC. However, other means may be used. For example, the lift pins 13 may be polished with a material harder than SiC, such as diamond or the like.

It is needless to say that the others can be modified appropriately in a range within the scope of the present invention.

### Industrial Applicability

According to the present invention, since the surface of each lift pin that slides in contact with the susceptor is polished, the abraded particles generated when the lift pins are slid can be reduced considerably. Thereby, no foreign material, such as abraded particles or the like, adheres to the substrate even though the lift pins are slid, and adhesion of particles or generation of crystal defects on the thin film which is grown on the substrate in vapor phase can be reduced considerably. Therefore, the vapor phase growth apparatus of the present invention is particularly suitable for manufacturing a semiconductor substrate by growing a single crystal thin film in vapor phase on a substrate, such as silicon wafer or the like.

## Claims

1. A vapor phase growth apparatus comprising:
a reaction chamber;
a susceptor for placing a substrate thereon, the susceptor being provided in the reaction chamber;
a pocket portion formed in the susceptor, the pocket portion being provided with through holes; and
lift pins each of which is inserted into each of the through holes, the lift pins being arranged so as to slide freely;
wherein installation and removal of the substrate on the susceptor are made by making the lift pins go up and down and making the lift pins be in contact with and separated from a rear surface of the substrate, and a surface of each of the lift pins that slides in contact with the susceptor is polished.

2. The vapor phase growth apparatus as claimed in claim 1, wherein the surface of each of the lift pins that slides in contact with the susceptor is formed so that surface roughness is not more than 5 µm.

3. The vapor phase growth apparatus as claimed in claim 1 or 2, wherein a surface of the susceptor that slides in contact with each of the lift pins is formed so that surface roughness is not more than 5 µm.

4. The vapor phase growth apparatus as claimed in any one of claims 1 to 3, wherein a surface of each of the lift pins and a surface of the susceptor are formed by SiC.

## Patentansprüche

1. Dampfphasenepitaxie-Vorrichtung, umfassend:
eine Reaktionskammer,
einen Suszeptor zum Platzieren eines Substrats darauf, wobei der Suszeptor in der Reaktionskammer bereitgestellt ist,
einen Taschenteil, ausgebildet in dem Suszeptor, wobei der Taschenteil mit Durchgangsbohrungen versehen ist, und
Hebestifte, von denen jeder in jede der Durchgangsbohrungen eingeführt wird, wobei die Hebestifte so eingerichtet sind, dass sie frei gleiten,
wobei Installieren und Entfernen des Substrats auf und von dem Suszeptor dadurch erfolgt, indem die Hebestifte nach oben und nach unten bewegt werden und die Hebestifte mit einer Rückseitenfläche des Substrats in Kontakt gebracht werden und von dieser getrennt werden, und wobei eine Fläche von jedem der Hebestifte, die in Kontakt mit dem Suszeptor gleitet, poliert ist.

2. Dampfphasenepitaxie-Vorrichtung nach Anspruch 1, wobei die Fläche jedes der Hebestifte, die in Kontakt mit dem Suszeptor gleitet, so ausgebildet ist, dass die Rautiefe nicht mehr als 5 µm ist.

3. Dampfphasenepitaxie-Vorrichtung nach Anspruch 1 oder 2, wobei eine Fläche des Suszeptors, die in Kontakt mit jedem der Hebestifte gleitet, so ausgebildet ist, dass die Rautiefe nicht mehr als 5 µm ist.

4. Dampfphasenepitaxie-Vorrichtung nach einem der Ansprüche 1 bis 3, wobei eine Fläche jedes der Hebestifte und eine Fläche des Suszeptors aus SiC gebildet sind.

## Revendications

1. Appareil de croissance en phase vapeur comprenant:
une chambre de réaction;
un suscepteur sur lequel placer un substrat, le suscepteur étant prévu dans la chambre de réaction;
une portion en forme de poche formée dans le suscepteur, la portion en forme de poche étant pourvue de trous passants; et
des broches de levage, insérée chacune dans chacun des trous passants, les broches de levage étant agencées de façon à glisser librement;
dans lequel l'installation et l'enlèvement du substrat sur le suscepteur sont effectuées en faisant monter et descendre les broches de levage et en amenant les broches de levage en contact avec, et à l'écart d'une surface arrière du substrat, et une surface de chacune des broches de levage qui glisse en contact avec le suscepteur est polie.

2. Appareil de croissance en phase vapeur selon la revendication 1, dans lequel la surface de chacune des broches de levage qui glisse en contact avec le suscepteur est formée de telle sorte que la rugosité de surface n'est pas supérieure à 5µm.

3. Appareil de croissance en phase vapeur selon la revendication 1 ou 2, dans lequel une surface du suscepteur qui glisse en contact avec chacune des broches de levage est formée de telle sorte que la rugosité de surface n'est pas supérieure à 5µm.

4. Appareil de croissance en phase vapeur selon l'une quelconque des revendications 1 à 3, dans lequel une surface de chacune des broches de levage et une surface du suscepteur sont formées de SiC.
